Europäisches Patentamt

European Patent Office

Office européen des brevets

(19)

(11) Numéro de publication : **0 109 331
B1**

(12)

# FASCICULE DE BREVET EUROPÉEN

(45) Date de publication du fascicule du brevet :
03.12.86

(21) Numéro de dépôt : 83402123.0

(22) Date de dépôt : 28.10.83

(51) Int. Cl.⁴ : **H 01 L 29/743**, H 01 L 29/08

(54) **Thyristor asymétrique à forte tenue en tension inverse.**

(30) Priorité : 10.11.82 FR 8218904

(43) Date de publication de la demande :
23.05.84 **Bulletin 84/21**

(45) Mention de la délivrance du brevet :
03.12.86 **Bulletin 86/49**

(84) Etats contractants désignés :
**CH DE GB LI**

(56) Documents cités :
DE-A- 1 489 694
DE-A- 1 514 151
DE-A- 2 802 727
FR-A- 2 235 494
GB-A- 2 011 712

(73) Titulaire : **LE SILICIUM SEMICONDUCTEUR SSC
101, Boulevard Murat
F-75016 Paris (FR)**

(72) Inventeur : **Felici, Maurizio
THOMSON-CSF SCPI 173, bld Haussmann
F-75379 Paris Cedex 08 (FR)**

(74) Mandataire : **Guérin, Michel et al
THOMSON-CSF SCPI 19, avenue de Messine
F-75008 Paris (FR)**

EP 0 109 331 B1

## Description

La présente demande concerne le domaine des composants semiconducteurs de forte puissance et, plus particulièrement, elle concerne un thyristor de type asymétrique à forte tenue en tension inverse.

Les caractéristiques et avantages des thyristors asymétriques sont par exemple décrits dans l'article « New developments in asymmetrical power thyristors » de P. Bacuvier, R. Pezzani, J. C. Salbreux et A. Sénès publié dans les Proceedings of the Second International Power conversion Conference, Munich, septembre 1980.

Il est notamment exposé dans cet article qu'un avantage essentiel des thyristors asymétriques par rapport aux thyristors classiques est que les premiers permettent d'obtenir des temps de fermeture beaucoup plus brefs tout en gardant les mêmes caractéristiques de tenue en tension directe. Toutefois, les thyristors asymétriques décrits dans cet article présentent une très faible tenue en tension inverse ou capacité de blocage en inverse, indiquée dans l'article comme étant de l'ordre de 20 volts tandis que la tenue en tension directe est, dans l'un des exemples donnés, de l'ordre de 2 400 volts. Il est exposé également dans cet article que cette mauvaise tenue en tension inverse des thyristors asymétriques est peu gênante dans de nombreux montages où le thyristor se trouve en parallèle sur une diode tête-bêche et n'a donc pas de tension inverse importante à supporter.

Effectivement, si pour cette application la tenue en tension inverse est sans grande importance, il existe d'autres applications des thyristors pour lesquelles on souhaite bénéficier des avantages de rapidité existant dans les thyristors asymétriques, mais où l'on souhaite également bénéficier d'une tenue en tension inverse non négligeable.

Un objet de la présente invention est de prévoir un tel thyristor à tenue en tension inverse importante et à temps de fermeture bref.

Pour atteindre cet objet, la présente invention prévoit un thyristor asymétrique comprenant, de sa face supérieure à sa face inférieure, une couche de cathode N1, une couche de gâchette P1, une couche de base N2 N2$^+$ asymétrique, la zone N2$^+$ plus fortement dopée se trouvant du côté de la face inférieure, une couche d'anode P2 et en outre, entre la zone N2$^+$ plus fortement dopée et la couche d'anode P2, une couche supplémentaire P2$^-$ moins dopée que la couche N2$^+$. Cette couche P2$^-$ peut notamment être formée par épitaxie.

Pour mieux faire comprendre la présente invention, on va d'abord définir les caractéristiques structurelles d'un thyristor influant sur sa tenue en tension inverse. On rappellera aussi certaines explications théoriques sur les phénomènes physiques intervenant quand un thyristor se trouve à l'état bloqué. Néanmoins, même si les théories actuelles rappelées ci-après sur le blocage s'avèrent erronées, le thyristor asymétrique selon l'invention est défini par ses caractéristiques structurelles et une erreur dans l'exposé théorique ne saurait influer sur la présente invention dont les avantages ont été prouvés expérimentalement.

La description ci-après, qui rappelle les structures de l'art antérieur et leur fonctionnement ainsi que la structure et le fonctionnement d'un thyristor asymétrique selon la présente invention, sera faite en relation avec les figures jointes parmi lesquelles :

les figures 1A, 1B et 1C représentent respectivement une vue en coupe schématique, un profil de concentration, et une distribution de champ électrique pour un thyristor symétrique classique,

les figures 2A, 2B et 2C sont des figures analogues pour un thyristor asymétrique classique,

les figures 3A, 3B et 3C sont des figures analogues pour un thyristor asymétrique selon la présente invention,

les figures 4B et 4C sont des vues analogues aux figures 3B et 3C pour une variante de réalisation selon la présente invention.

De façon générale, on notera qu'aucune de ces figures n'est représentée à l'échelle, ni à l'intérieur d'une figure donnée, ni d'une figure à l'autre. Par contre, de mêmes notations sont utilisées pour désigner des couches analogues dans les diverses figures.

La figure 1A représente une vue en coupe très schématique d'un thyristor symétrique classique. On peut y voir la couche de cathode N1, la couche de gâchette P1, la couche de base N2 et la couche d'anode P2. Des métallisations (non représentées) de cathode, de gâchette et d'anode sont solidaires des couches N1, P1 et P2 respectivement.

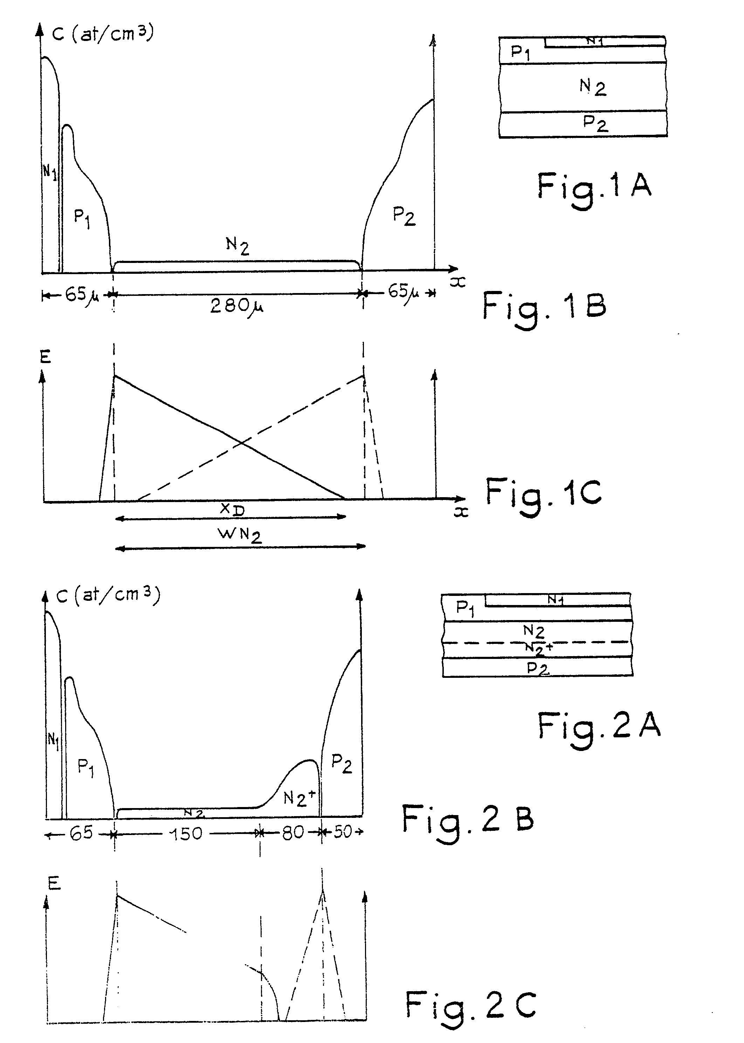

La figure 1B représente à titre d'exemple la répartition des concentrations de dopants dans un thyristor du type de celui de la figure 1A. On peut y voir un substrat N2 dans lequel sont réalisées de part et d'autre, par diffusion, des couches de type P, P1 et P2. Du côté de la couche P1, est réalisée une diffusion de cathode N1 à concentration superficielle élevée. Dans la vue représentée, on peut remarquer une rupture de pente dans les profils de concentration des couches P1 et P2. Ceci est destiné à montrer que, dans des cas pratiques fréquents, ces couches P1 et P2 sont réalisées par deux diffusions successives : une diffusion profonde à faible concentration superficielle, puis une diffusion moins profonde à concentration superficielle élevée permettant de prendre un contact d'anode satisfaisant sur la face d'anode. A titre d'exemple numérique, pour un thyristor destiné à supporter une tension de l'ordre de 2 400 volts : la couche de substrat N2 aura une épaisseur de l'ordre de 280 microns, et un niveau de dopage de l'ordre de 10$^{13}$ à 10$^{14}$ atomes/cm$^3$ ; les couches P1 et P2 auront une épaisseur de l'ordre de 65 microns, la couche P2 ayant une concentration superficielle de dopant de l'ordre de $10^{18}$ à $10^{20}$ atomes/cm$^3$ ; et la couche N1 pénétrera dans la couche P1 d'une profondeur de l'ordre de 10 microns avec une concentration superficielle de l'ordre de $10^{20}$ à $10^{21}$ atomes/cm$^3$. Mais, bien entendu, les valeurs de ces divers paramètres sont fixées en fonction des caractéristiques que l'on souhaite obtenir pour le thyristor. Il n'en reste pas moins que l'épaisseur de la couche N2 restante est fonction de la tension maximale que le thyristor doit supporter. En première approximation, on considère que le thyristor peut supporter environ 10 volts par micron d'épaisseur de la couche N2. On trouve bien une épaisseur supérieure à 240 microns pour pouvoir supporter une tension de 2 400 volts.

La figure 1C représente la répartition du champ électrique dans le thyristor quand celui-ci se trouve à l'état bloqué. La courbe en trait plein représente la répartition du champ électrique quand le thyristor est bloqué en direct. C'est alors la jonction P1/N2 qui agit. La décroissance du potentiel est très forte dans la couche P1 fortement dopée et beaucoup plus lente dans la couche N2 faiblement dopée. Comme le montre la figure 1C, il faut que l'épaisseur sur laquelle s'atténue et s'annule le champ électrique, désignée par la référence $X_D$, soit inférieure à l'épaisseur WN2 de la couche N2 pour que le thyristor puisse bloquer toute la tension correspondant à la concentration des dopants dans la région N2, tout en évitant le phénomène de perçage couramment désigné par l'appellation anglo-saxonne « punch-through » qui diminuerait fortement la tension maximum blocable. La courbe en tiretés indique la répartition du champ électrique quand le thyristor est bloqué en inverse, en supposant que c'est essentiellement la jonction P2/N2 qui assure le blocage, la jonction P1/N1 ayant un effet négligeable. Les courbes de répartition du champ en direct et en inverse sont symétriques et le thyristor aura sensiblement la même capacité de blocage dans les deux cas.

Dans un tel thyristor symétrique, l'écart WN2-$X_D$ doit être suffisant pour que le gain du transistor PNP constitué par la couche de gâchette P1, la couche de base N2 et l'émetteur P2 soit suffisamment faible à haute tension, où l'épaisseur effective se réduit à la valeur WN2-$X_D$.

Mais, le temps de fermeture $t_q$ d'un thyristor est directement lié à la valeur de l'épaisseur de la couche N2 et plus cette couche N2 est épaisse, plus ce temps de fermeture est important. Ainsi, inévitablement, les thyristors symétriques de forte tenue en tension ont nécessairement des temps de fermeture élevés et des pertes en commutation importantes.

Comme cela est exposé dans l'article sus-mentionné, pour permettre de réduire ces temps de fermeture et d'améliorer les caractéristiques de commutation, on a eu recours à l'utilisation de thyristors asymétriques. Un thyristor asymétrique est schématiquement représenté en coupe en figure 2A. En plus des couches représentées en figure 1A, il comprend à l'interface entre la couche de base N2 et la couche d'anode P2, une zone de base surdopée N2$^+$.

Les profils de concentration d'un tel thyristor asymétrique sont illustrés en figure 2B. On peut y voir la couche N2$^+$ à l'interface entre les couches N2 et P2.

La distribution du champ à l'état bloqué est représentée schématiquement en figure 2C. Le champ électrique baisse rapidement dans la couche N2$^+$ et l'on peut donc, pour une épaisseur beaucoup plus faible de la couche N2, tenir une tension élevée alors que le champ s'annule dans la couche N2$^+$ sans atteindre la couche d'anode P2. Il est connu, comme l'indique notamment l'article sus-mentionné, qu'un tel thyristor peut tenir une tension directe aussi importante que la tension directe d'un thyristor symétrique avec une épaisseur de couche de base sensiblement deux fois plus élevée, cette couche de base, en raison de la structure P1 N2 N2$^+$, pouvant tenir une tension de l'ordre de 20 volts par micron d'épaisseur et non plus de 10 volts par micron. On obtient donc alors, pour une même tenue en tension directe VDRM, une épaisseur de couche de base deux fois plus faible et donc un temps de commutation au moins deux fois plus faible. A titre d'exemple numérique, la couche N2 peut avoir une épaisseur de l'ordre de 150 microns et la couche N2$^+$ une épaisseur de l'ordre de 80 microns pour tenir toujours une tension directe de l'ordre de 2 400 volts. Mais, l'inconvénient d'une telle structure, comme on peut le déduire de la distribution du champ électrique illustrée en tiretés en figure 2C, est que sa tenue en tension inverse est très faible, seulement de l'ordre de 10 à 20 volts. En effet, la couche N2$^+$ devrait répondre à deux exigences contradictoires et difficilement conciliables : avoir un dopage total élevé (pour bien bloquer la région de charge d'espace et réduire la valeur du gain en courant du transistor P1N2N2$^+$P2 à haute tension) et présenter une faible concentration de dopants à la jonction N2$^+$/P2 (pour augmenter la tenue en tension inverse VRRM proportionnelle à $1/Co^{3/4}$, Co étant la concentration maximale de la couche N2$^+$). La structure asymétrique est donc bien inadéquate si l'on veut obtenir des valeurs de tenue en tension inverse VRRM supérieures à 10 à 20 volts. Même dans le cas décrit antérieurement où le thyristor asymétrique est monté en antiparallèle avec une diode, cette valeur est relativement faible si l'on tient compte de surcharges éventuelles provoquées par les inductances parasites du circuit et du composant.

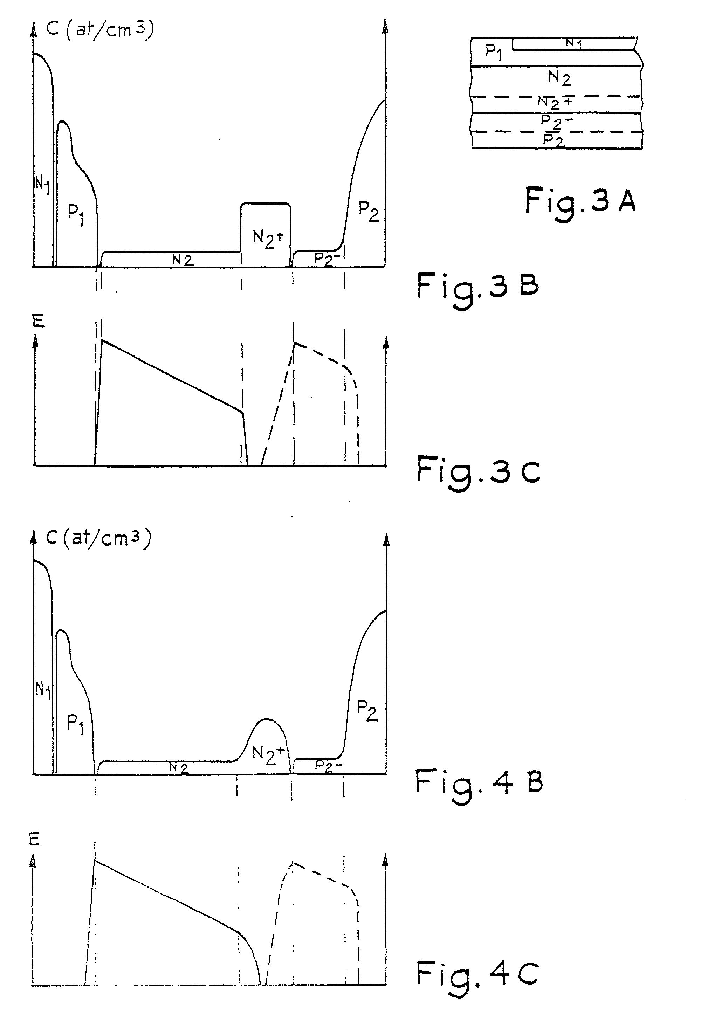

La structure selon la présente invention, destinée à maintenir les avantages de faible valeur de la durée de fermeture $t_q$ liée aux thyristors asymétriques tout en permettant l'obtention d'une tenue en tension inverse VRRM élevée, va être décrite ci-après en relation avec les figures 3 et 4.

La figure 3A représente une vue en coupe schématique d'un thyristor asymétrique selon la présente invention. Outre les couches déjà représentées en figure 2A pour un thyristor asymétrique classique, le thyristor selon l'invention comprend une couche supplémentaire P2⁻, à plus faible niveau de dopage que N2⁺, comprise à l'interface entre la zone N2⁺, à niveau de dopage plus élevé que celui du substrat N2, et la couche d'anode P2. Selon une forme de réalisation préférée, le niveau de dopage de cette couche P2⁻ est du même ordre que celui de la couche de substrat N2, mais, bien entendu, de type de conductivité opposée.

Le profil de concentration de la structure illustrée en figure 3A est représenté à titre d'exemple en figure 3B dans le cas où les couches N2⁺ et P2⁻ sont obtenues par épitaxie. Comme le montre la figure 3B, une double épitaxie N2⁺, puis P2⁻ est réalisée sur le substrat N2. Une couche d'anode P2 est ensuite formée sur la couche épitaxiée P2⁻. Les couches de gâchette et de cathode P1 et N1 peuvent être formées avant ou après les épitaxies N2 et P2. Néanmoins, pour mieux contrôler le profil des dopants du côté de l'anode, il peut être préférable de faire les diffusions de gâchette P1 et d'émetteur N1 avant les épitaxies.

Avec la structure de la figure 3B, on obtient à l'état bloqué les répartitions de champ électrique illustrées en figure 3C en trait plein pour le blocage en direct et en pointillés pour le blocage en inverse. Pour le blocage en direct, on est dans le même état que dans le cas de la figure 2C, c'est-à-dire dans le cas classique. En ce qui concerne le blocage en inverse, la tenue en tension inverse va dépendre de l'épaisseur et du niveau de dopage de la couche P2⁻. Ces valeurs peuvent être choisies très librement sans influer sur les paramètres principaux du thyristor considéré précédemment, à savoir sa tenue en tension en direct et son temps de fermeture qui dépendent, eux, des caractéristiques des couches N2 et N2⁺. On a donc, avec la présente invention, effectivement découplé les paramètres liés à la tenue en tension directe et à la tenue en tension inverse.

A titre d'exemple, si le niveau de dopage de la couche P2⁻ est de $3 \cdot 10^{15}$ atomes/cm³ et son épaisseur de l'ordre de 10 microns, on obtient une capacité de tenue en inverse de l'ordre de 130 volts.

Les figures 4B et 4C représentent les profils de concentration et la distribution du champ électrique dans le cas d'une structure selon la présente invention du type de celle de la figure 3A, mais dans laquelle la couche N2⁺ est formée par diffusion ou par implantation suivie d'une diffusion et non plus par épitaxie. Dans ce cas, les angles de la courbe de distribution du champ électrique sont plus arrondis, mais globalement les phénomènes restent les mêmes. L'avantage de cette structure est d'éviter une épitaxie et donc de simplifier quelque peu le processus de fabrication.

La présente invention est susceptible de nombreuses variantes accessibles à l'homme de l'art à partir des exemples donnés précédemment, notamment en ce qui concerne le mode de réalisation des couches par diffusion, implantation ionique ou épitaxie. On notera également que l'on peut inverser tous les types de conductivité si l'on prévoit un thyristor à gâchette d'anode et non plus un thyristor à gâchette de cathode. La présente invention pourra aussi s'appliquer à des thyristors plus complexes du type thyristor à ouverture par la gâchette ou à ouverture assistée par la gâchette.

## Revendications

1. Thyristor asymétrique à forte tenue en tension inverse comprenant de sa face supérieure à sa face inférieure une couche de cathode N1, une couche de gâchette P1, une couche de base N2 N2⁺ asymétrique, la zone N2⁺ plus fortement dopée se trouvant du côté de la face inférieure, une couche d'anode P2, caractérisé en ce qu'il comprend en outre, entre la zone N2⁺ plus fortement dopée et la couche d'anode P2, une couche supplémentaire P2⁻ moins dopée que la couche N2⁺.

2. Thyristor selon la revendication 1, caractérisé en ce que la couche P2⁻ est formée par épitaxie.

3. Thyristor selon l'une des revendications 1 ou 2, caractérisé en ce que la couche N2⁺ est formée par épitaxie.

4. Thyristor selon la revendication 1, caractérisé en ce que la couche P2⁻ a un niveau de dopage du même ordre que celui de la couche N2, mais un type de conductivité opposé.

## Claims

1. Asymmetric thyristor with high reverse voltage strength, comprising, from its upper face to its lower face, a cathode N1 layer, a P1 gate layer, an asymmetric N2 N2⁺ base layer, the higher doped N2⁺ zone being located on the side of the lower face, and a P2 anode layer, characterized in that it further comprises an additional P2⁻ layer less doped than the N2⁺ layer between the higher doped N2⁺ zone and the P2 anode layer.

2. Thyristor according to claim 1, characterized in that the P2⁻ layer is formed by epitaxy.

3. Thyristor according to claims 1 or 2, characterized in that the N2⁺ layer is formed by epitaxy.

4. Thyristor according to claim 1, characterized in that the P2⁻ layer has a doping level of the same order as that of the N2 layer, but is of opposite conductivity type.

## Patentansprüche

1. Asymmetrischer Thyristor mit hoher Sperrspannungsfestigkeit, welcher von seiner Oberseite zu seiner Unterseite eine N1-Kathodenschicht, eine P1-Gate-Schicht, eine asymmetrische Basisschicht vom Typ N2 N2⁺, wobei die stärker dotierte N2⁺-Zone sich auf der Seite der unteren Fläche befindet, und eine P2-Anodenschicht umfaßt, dadurch gekennzeichnet, daß er ferner zwischen der höher dotierten N2$^+$-Zone und der P2-Anodenschicht eine zusätzliche P2$^-$-Schicht aufweist, die schwächer dotiert ist als die N2$^+$-Schicht.

2. Thyristor nach Anspruch 1, dadurch gekennzeichnet, daß die P2$^-$-Schicht epitaktisch gebildet ist.

3. Thyristor nach Anspruch 1 oder 2, dadurch gekennzeichnet, daß die N2$^+$-Schicht epitaktisch gebildet ist.

4. Thyristor nach Anspruch 1, dadurch gekennzeichnet, daß die P2$^-$-Schicht ein Dotierungsniveau von gleicher Größenordnung wie die N2-Schicht aufweist, jedoch den entgegengesetzten Leitungstyp besitzt.

Fig.1 A

Fig. 1 B

Fig. 1C

Fig. 2 A

Fig. 2 B

Fig. 2 C

1

C (at/cm³)

N₁

P₁

N₂

N₂⁺

P₂⁻

P₂

Fig. 3 A

Fig. 3 B

E

Fig. 3 C

C (at/cm³)

N₁

P₁

N₂

N₂⁺

P₂⁻

P₂

Fig. 4 B

E

Fig. 4 C